# EUROPEAN PATENT APPLICATION

(11) **EP 4 565 015 A1**
(43) Date of publication of application: **04.06.2025**
(21) Application number: 23213238.1
(22) Date of filing: 30.11.2023
(51) Int. Cl.: H05K 3/22, H05K 1/02, H05K 3/36

(54) **PRINTED CIRCUIT BOARD ASSEMBLY WITH LIFE EXPECTANCY COMPONENT SEPARATION**

(71) Applicant: VOLVO TRUCK CORPORATION, 405 08 Göteborg (SE)
(72) Inventor: Grahn, Pontus, 413 11 Göteborg (SE)
(74) Representative: Valea AB

(57) **Abstract**

A modular printed circuit board assembly (100) and method for configuring the modular printed circuit board assembly (100) are provided. The modular printed circuit board assembly (100) comprises two or more printed circuit board sub-assemblies (101, 102, 103), wherein each printed circuit board sub-assembly (101, 102, 103) comprises a group of surface mounted components having a life expectancy within a certain time range, and wherein the two or more printed circuit board sub-assemblies (101, 102, 103) are connected based on a function of the printed circuit board assembly (100), and each printed circuit board sub-assembly (101, 102, 103) is configured to be independently replaceable when the group of components on it approaches the end of the life expectancy.

## Description

### TECHNICAL FIELD

The disclosure relates generally to printed circuit board assembly (PCBA). In particular aspects, the disclosure relates to a modular PCBA comprising two or more printed circuit board sub-assemblies.

The disclosure can be applied to any electronic apparatus or devices and any vehicles comprising electronic devices. Although the disclosure may be described with respect to a particular electronic device comprised in a particular vehicle, the disclosure is not restricted to any particular electronic device and vehicle.

### BACKGROUND

Vehicles usually comprise electronic devices which comprise one or more PCBAs with certain required functions such as voltage converters, inverters, control units, monitoring units etc. Generally, all components building up a certain function, e.g. a direct current to direct current (DC-DC) converter, an alternating current to direct current (AC-DC) converter etc., are surface mounted on the same PCBA. This creates a problem when trying to maintain the PCBA. If some components are broken, destroyed or out of function, the whole PCBA has to be replaced since everything is on the same PCBA. If trying to replace the components which are broken, destroyed or out of function, one must melt the solder joints of these components and weld the new components. This is time consuming, and it is difficult to ensure that the PCBA still keeps good quality and function without extensive testing. Nowadays, there is no efficient solution regarding maintenance of PCBAs. Replacing the entire PCBA is not environmentally and cost friendly.

### SUMMARY

This disclosure provides a solution to improve the maintenance of PCBAs. The components may be divided into different categories dependent on their life expectancy. The components may be divided into 2 or more categories by their life expectancy. Then these components may be placed on different sub-PCBAs, and the sub-PCBAs can be connected to each other. If some of the short life expectancy components break, one can just replace that sub-PCBA, instead of replacing the entire PCBA or trying to loosen and resolder the joints for the specific components.

According to a first aspect of the disclosure, a modular printed circuit board assembly comprising two or more printed circuit board sub-assemblies is provided. Each printed circuit board sub-assembly comprises a group of surface mounted components having a life expectancy within a certain time range. The two or more printed circuit board sub-assemblies are connected based on a function of the printed circuit board assembly, and each printed circuit board sub-assembly is configured to be independently replaceable when the group of components on it approaches the end of the life expectancy.

Optionally in some examples, including in at least one preferred example, the two or more printed circuit board sub-assemblies may comprise a first printed circuit board sub-assembly having a group of surface mounted components with a short life expectancy, a second printed circuit board sub-assembly having a group of surface mounted components with a middle life expectancy, and a third printed circuit board sub-assembly having a group of surface mounted components with a long life expectancy.

The first aspect of the disclosure may seek to provide an improved modular printed circuit board assembly which can be maintained easily and environmentally and cost friendly. PCBAs and electrical components rely on many dangerous chemicals for their manufacture, including formaldehyde and phthalates, both of which can poison the environment when they are discarded. Keeping as many components on the PCBAs as possible and keeping the PCBAs as long as possible rather than disposing them will prolong the supplies, limit environmental impact and save cost.

According to a second aspect of the disclosure, a vehicle comprising a modular printed circuit board assembly as described above is provided.

According to a third aspect of the disclosure, an electronic apparatus comprising a modular printed circuit board assembly as described above is provided.

According to a fourth aspect of the disclosure, a method for configuring a modular printed circuit board is provided. The method comprises categorizing components to be surface mounted on the modular printed circuit board assembly into two or more groups based on their life expectancy, wherein each group of the components have a life expectancy within a certain time range. The method further comprises surface mounting each group of the components on a respective one of two or more printed circuit board sub-assemblies and connecting the two or more printed circuit board sub-assemblies based on a function of the modular printed circuit board assembly.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

### BRIEF DESCRIPTION OF THE DRAWINGS

Examples are described in more detail below with reference to the appended drawings.
**Fig. 1** is a schematic block diagram showing a modular printed circuit board assembly according to an example.
**Fig. 2** is a flow chart showing a method for configuring a modular printed circuit board assembly according to an example.
**Fig. 3** is a schematic block diagram showing an electronic device according to an example.
**Fig. 4** is a schematic block diagram showing a vehicle according to an example.

### DETAILED DESCRIPTION

The detailed description set forth below provides information and examples of the disclosed technology with sufficient detail to enable those skilled in the art to practice the disclosure.

The lifetime of PCBAs depends on how its major components are degraded with time. The components differ from one another in terms of lifetime. The disclosure provides a solution to improve the lifetime and maintenance of PCBAs. The components may be divided into different categories dependent on their life expectancy. The components may be divided into 2 or more categories, e.g., by short, middle and long and life expectancy. Then these components may be placed on different sub-PCBAs, and the sub-PCBAs can be connected to each other. If some of the short life expectancy components break, one can just replace that sub-PCBA, instead of replacing the entire PCBA or trying to loosen and resolder the joints for the broken components.

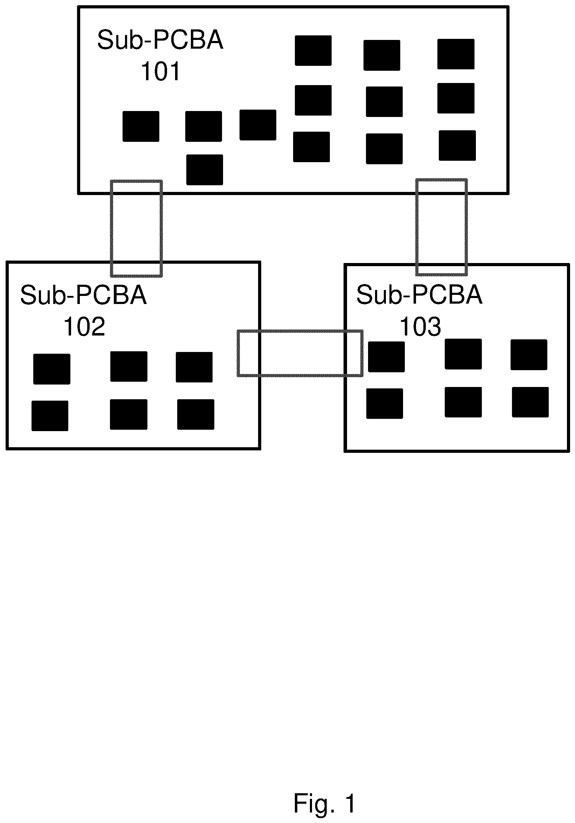

**Fig. 1** is a schematic block diagram showing a modular printed circuit board assembly PCBA 100 with improved lifetime and easy maintenance according to an example. The modular printed circuit board assembly **100** comprises two or more printed circuit board sub-assemblies (sub-PCBA), e.g. **sub-PCBA 101, 102, 103.** Each printed circuit board sub-assembly sub-PCBA 101, 102, 103 comprises a group of surface mounted components having a life expectancy within a certain time range. For example, a group of surface mounted components may have substantially the same life expectancy, and substantially the same life expectancy may mean a difference of the life expectancies between the group of components is less than a predefined time range. For example, the difference of the life expectancies between the group of components may be less than 1 or 2 years. For example, a first printed circuit board sub-assembly 101 may have a group of surface mounted components with a short life expectancy, e.g. around 5 years or 5±1 years, a second printed circuit board sub-assembly 102 may have a group of surface mounted components with a middle life expectancy, e.g. around 10 years or 10±1 years, a third printed circuit board sub-assembly 103 may have a group of surface mounted components with a long life expectancy, e.g. around 20 years or 20±1 years.

The two or more printed circuit board sub-assemblies sub-PCBA 101, 102, 103 are connected based on a function of the printed circuit board assembly 100, e.g. the printed circuit board assembly 100 may have a function of a voltage converter, an inverter, a control unit, a monitoring unit etc. or a combination of these functions. Each printed circuit board sub-assembly sub-PCBA 101, 102, 103 is configured to be independently replaceable when the group of components on it approaches the end of the life expectancy.

Note that Fig. 1 is just to show the separation principle of the modular printed circuit board assembly 100. How many sub-PCBAs the modular printed circuit board assembly 100 may be separated to, how the sub-PCBAs may be connected to each other, and how the sub-PCBAs may be positioned and arranged to each other, will depend on the actual applications and situations.

The two or more printed circuit board sub-assemblies sub-PCBA 101, 102, 103 may be connected by any suitable connectors, e.g. any one or a combination of a board-to-board connector, a press fit connector or a backplane connector so that the printed circuit board sub-assemblies sub-PCBA 101, 102, 103 are flexible and easily replaceable.

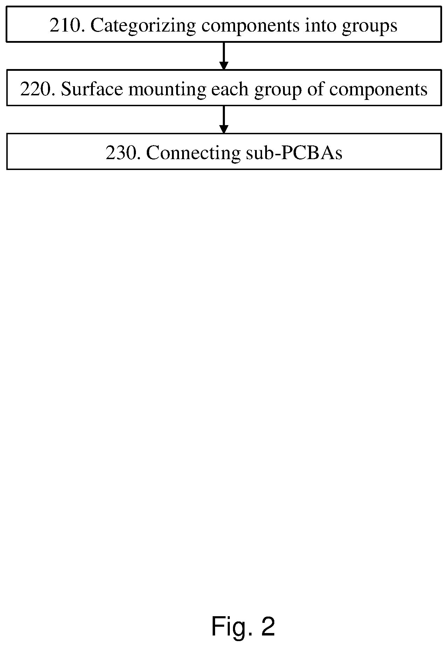

**Fig. 2** is a flow chart showing a method for configuring a modular printed circuit board assembly 100 according to an example. The method comprises the following actions.

### Action 210

Categorizing components to be surface mounted on the modular printed circuit board assembly 100 into two or more groups based on their life expectancy. Each group of the components have a life expectancy within a certain time range, e.g. each group of the components may have substantially equal or same life expectancy e.g., 3±1 years, 5±1 years, 10±1, 20±1 years etc.

### Action 220

Surface mounting each group of the components on a respective one of two or more printed circuit board sub-assemblies sub-PCBA 101, 102, 103. For example, surface mounting a first group of components with a short life expectancy, e.g. 3±1 years, or 4±1 years, or 5±1 years, on a first printed circuit board sub-assembly sub-PCBA 101, surface mounting a second group of components with a middle life expectancy, e.g. 8±1 years or 10±1 years, on a second printed circuit board sub-assembly sub-PCBA 102, surface mounting a third group components with a long life expectancy, e.g. 15±1 years or 20±1 years, on a third printed circuit board sub-assembly sub-PCBA 103.

### Action 230

Connecting the two or more printed circuit board sub-assemblies sub-PCBA 101, 102, 103 based on a function of the modular printed circuit board assembly 100. For example, the two or more printed circuit board sub-assemblies sub-PCBA 101, 102, 103 may be connected by any one or a combination of e.g. a board-to-board connector, a press fit connector or a backplane connector etc., based on the function of the modular printed circuit board assembly 100, which may be e.g., any function of or a combination of a voltage converter, an inverter, a control unit, a monitoring unit, etc.

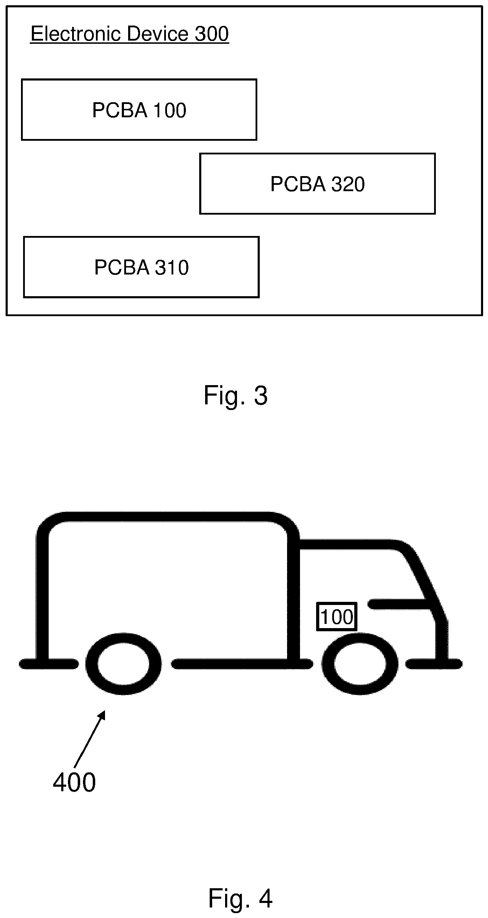

**Fig. 3** is a schematic diagram showing an electronic device **300** in which the disclosure may be implemented. The electronic device 300 may comprise one or more modular printed circuit board assembly PCBA 100 as described above. The electronic device 300 may comprise other PCBAs, e.g. PCBA **310** and PCBA **320.**

**Fig. 4** is a schematic diagram showing a vehicle **400** in which the disclosure may be implemented. The vehicle 400 may comprise one or more modular printed circuit board assembly PCBA 100 as described above.

To summarize, a modular printed circuit board assembly 100 and a method for configuring a modular printed circuit board assembly 100 are provided. The modular printed circuit board assembly 100 comprises two or more printed circuit board sub-assemblies. Each printed circuit board sub-assembly comprises a group of surface mounted components having a life expectancy within a certain time range. The two or more printed circuit board sub-assemblies are connected based on a function of the printed circuit board assembly, and each printed circuit board sub-assembly is configured to be independently replaceable when the group of components on it approaches the end of the life expectancy. The modular printed circuit board assembly 100 is easy to maintain and is environmentally and cost friendly.

The disclosure can be applied in any type of electronic devices and vehicles such as wagons, motor vehicles e.g. motorcycles, cars, trucks, buses, railed vehicles e.g. trains, trams, watercraft e.g. ships, boats, amphibious vehicles e.g. screw-propelled vehicle, hovercraft, aircraft e.g. airplanes, helicopters, aerostat and spacecraft etc.

Various examples are listed in the following.
**Example 1:** A modular printed circuit board assembly (100) comprising two or more printed circuit board sub-assemblies (101, 102, 103), wherein each printed circuit board sub-assembly (101, 102, 103) comprises a group of surface mounted components having a life expectancy within a certain time range, and wherein the two or more printed circuit board sub-assemblies (101, 102, 103) are connected based on a function of the printed circuit board assembly (100), and each printed circuit board sub-assembly (101, 102, 103) is configured to be independently replaceable when the group of components on it approaches the end of the life expectancy.
**Example 2:** The modular printed circuit board assembly (100) according to Example 1, wherein the two or more printed circuit board sub-assemblies (101, 102, 103) comprises a first printed circuit board sub-assembly (101) having a group of surface mounted components with a short life expectancy, a second printed circuit board sub-assembly (102) having a group of surface mounted components with a middle life expectancy, and a third printed circuit board sub-assembly (103) having a group of surface mounted components with a long life expectancy.
**Example 3:** The modular printed circuit board assembly (100) according to any one of Examples 1-2, wherein the modular printed circuit board assembly (100) has a function of any one or a combination of a voltage converter, an inverter, a control unit, a monitoring unit etc.
**Example 4:** The modular printed circuit board assembly (100) according to any one of Examples 1-3, wherein a group of surface mounted components having a life expectancy within a certain time range comprises components having substantially the same life expectancy, wherein substantially the same life expectancy means a difference of the life expectancies between the group of components is less than a predefined time range.
**Example 5:** The modular printed circuit board assembly (100) according to Example 4, wherein the predefined time range is 1 to 2 years.
**Example 6:** The modular printed circuit board assembly (100) according to any one of Examples 1-5, wherein the two or more printed circuit board sub-assemblies (101, 102, 103) are connected by any one or a combination of a board-to-board connector, a press fit connector, a backplane connector etc.
**Example 7:** A vehicle (400) comprising a modular printed circuit board assembly (100) according to any one of Examples 1-6.
**Example 8:** An electronic apparatus (300) comprising a modular printed circuit board assembly (100) according to any one of Examples 1-6.
**Example 9:** A method for configuring a modular printed circuit board assembly (100) comprising:
   categorizing (210) components to be surface mounted on the modular printed circuit board assembly (100) into two or more groups based on their life expectancy, wherein each group of the components have a life expectancy within a certain time range;
   surface mounting (220) each group of the components on a respective one of two or more printed circuit board sub-assemblies; and
   connecting (230) the two or more printed circuit board sub-assemblies based on a function of the modular printed circuit board assembly.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A modular printed circuit board assembly (100) comprising two or more printed circuit board sub-assemblies (101, 102, 103), wherein each printed circuit board sub-assembly (101, 102, 103) comprises a group of surface mounted components having a life expectancy within a certain time range, and wherein the two or more printed circuit board sub-assemblies (101, 102, 103) are connected based on a function of the printed circuit board assembly (100), and each printed circuit board sub-assembly (101, 102, 103) is configured to be independently replaceable when the group of components on it approaches the end of the life expectancy.

2. The modular printed circuit board assembly (100) according to claim 1, wherein the two or more printed circuit board sub-assemblies (101, 102, 103) comprises a first printed circuit board sub-assembly (101) having a group of surface mounted components with a short life expectancy, a second printed circuit board sub-assembly (102) having a group of surface mounted components with a middle life expectancy, and a third printed circuit board sub-assembly (103) having a group of surface mounted components with a long life expectancy.

3. The modular printed circuit board assembly (100) according to any one of claims 1-2, wherein the modular printed circuit board assembly (100) has a function of any one or a combination of a voltage converter, an inverter, a control unit, a monitoring unit.

4. The modular printed circuit board assembly (100) according to any one of claims 1-3, wherein a group of surface mounted components having a life expectancy within a certain time range comprises components having substantially the same life expectancy, wherein substantially the same life expectancy means a difference of the life expectancies between the group of components is less than a predefined time range.

5. The modular printed circuit board assembly (100) according to claim 4, wherein the predefined time range is 1 to 2 years.

6. The modular printed circuit board assembly (100) according to any one of claims 1-5, wherein the two or more printed circuit board sub-assemblies (101, 102, 103) are connected by any one or a combination of a board-to-board connector, a press fit connector, a backplane connector etc.

7. A vehicle (400) comprising a modular printed circuit board assembly (100) according to any one of claims 1-6.

8. An electronic apparatus (300) comprising a modular printed circuit board assembly (100) according to any one of claims 1-6.

9. A method for configuring a modular printed circuit board assembly (100) comprising:
categorizing (210) components to be surface mounted on the modular printed circuit board assembly (100) into two or more groups based on their life expectancy, wherein each group of the components have a life expectancy within a certain time range;
surface mounting (220) each group of the components on a respective one of two or more printed circuit board sub-assemblies; and
connecting (230) the two or more printed circuit board sub-assemblies based on a function of the modular printed circuit board assembly.
